# EUROPÄISCHE PATENTSCHRIFT

(11) **EP 2 165 204 B1**
(45) Veröffentlichungstag und Bekanntmachung des Hinweises auf die Patenterteilung: **20.04.2016**
(21) Anmeldenummer: 07803595.3
(22) Anmeldetag: 24.09.2007
(51) Int. Cl.: G01R 1/20, H01C 1/144

(54) **KRAFTFAHRZEUGBATTERIESENSORELEMENT SOWIE VERFAHREN ZUR HERSTELLUNG EINES KRAFTFAHRZEUGBATTERIESENSORELEMENTS**
VEHICLE BATTERY SENSOR ELEMENT AND METHOD FOR PRODUCING A MOTOR VEHICLE BATTERY SENSOR ELEMENT
ÉLÉMENT CAPTEUR DE BATTERIE DE VÉHICULE AUTOMOBILE ET PROCÉDÉ DE PRODUCTION D'UN ÉLÉMENT CAPTEUR DE BATTERIE DE VÉHICULE AUTOMOBILE

(30) Priorität: 13.07.2007 DE 102007033182
(43) Veröffentlichungstag der Anmeldung: 24.03.2010
(73) Patentinhaber: Auto-Kabel Management GmbH, 79688 Hausen i.W. (DE)
(72) Erfinder: GRONWALD, Frank, 50181 Bedbur (DE); NENTWIG, Dominik, 59368 Werne (DE)
(74) Vertreter: Cohausz & Florack
(86) Internationale Anmeldenummer: PCT/EP2007/060104
(87) Internationale Veröffentlichungsnummer: WO 2009/010103

(56) Entgegenhaltungen:
- EP-A- 1 030 185
- EP-A- 1 435 524
- DE-A1-102004 055 848
- DE-U1- 20 318 266
- FR-A- 2 884 615
- GB-A- 1 018 848

## Beschreibung

### Die Anmeldung betrifft ein

Kraftfahrzeugbatteriesensorelement mit einem Widerstandselement und zumindest zwei auf dem Widerstandselement angeordneten, räumlich voneinander getrennten elektrischen Kontakte. Ferner betrifft die Anmeldung ein Verfahren zur Herstellung eines solchen Kraftfahrzeugbatteriesensorelements.

In heutigen Kraftfahrzeugen nimmt die Anzahl der elektrischen Verbraucher ständig zu. Neben den wesentlichen Motorfunktionen, welche elektrisch versorgt werden, wie beispielsweise die des Starters, befinden sich in Fahrzeugen eine Vielzahl von Komfortverbrauchern, wie beispielsweise Klimaanlage, Navigationssystem, Bordcomputer, Unterhaltungselektronik und dergleichen. Die Vielzahl der Komfortverbraucher führt zu einer erhöhten Belastung der Kraftfahrzeugbatterie. Selbst im Stillstand des Kraftfahrzeugs wird Energie von der Batterie abgerufen. Dies führt dazu, dass die Batterie nicht mehr nur für die ursprünglichen Aufgaben der Versorgung des Starters mit Startstrom Verwendung findet, sondern die gesamte Elektronik im Fahrzeug mit Energie versorgt.

Aus den zuvor genannten Gründen ist es notwendig, den Zustand einer Batterie sicher bestimmen zu können. Hierzu sind in der Vergangenheit eine Vielzahl von Kraftfahrzeugbatteriesensoren vorgeschlagen worden. Diese Kraftfahrzeugbatteriesensoren sind bevorzugt unmittelbar an den Batteriemessklemme angeordnet. So ist beispielsweise aus der EP 0 990 167 eine Batteriemessklemme bekannt, welche über einen Widerstand (Shunt) neben dem Strom im Energieleiter der Batterie auch die Spannung und/oder die Temperatur misst und beispielsweise anhand dieser Werte den Zustand der Batterie auswertet. Zur Auswertung des Batteriezustands ist es notwendig, die über den Shunt abfallende Spannung genau messen zu können. Die Auswertung ist stark abhängig von der Qualität des Spannungsabgriffes über dem Shunt. Somit kommt der Gestaltung des Shunts eine maßgebliche Bedeutung für die Messsensorik zu.

Die US 6,304,062 zeigt beispielsweise einen Batteriesensor, bei welchem der Messwiderstand plattenförmig gebildet ist und Abgriffe vorgesehen sind, über welche die über dem Messwiderstand abfallende Spannung gemessen werden kann.

Die EP 1 435 524 A1 zeigt eine Batteriesensorvorrichtung, bei der über Lötpunkte eine integrierte Schaltung auf einem Shunt aufgebracht ist.

Die DE 203 18 266 U1 zeigt eine Vorrichtung zur Strommessung, bei der Klemmkörper am Shunt angeordnet sind, an denen ein integrierter Schaltkreis befestigt und kontaktiert werden kann.

Die DE 10 2005 019 569 A1 zeigt einen Shunt, der mittels Hartlöten an einer Batteriepolklemme befestigt ist. Über Pins wird eine integrierte Schaltung kontaktiert.

Bei den bekannten Widerstandselementen, welche heutzutage verwendet werden, ist es notwendig, ein Widerstandsstück zwischen zwei Anschlussstücken anzuordnen. So wird heutzutage beispielsweise eine CuMn12Ni-Legierung (Manganin) als Widerstandsstück verwendet. Das Manganin wird zwischen zwei Anschlussstücken aus Kupfer angeordnet. Bei der Herstellung werden beispielsweise die als Flachteile gebildeten Anschlussstücke mit dem als Flachteil gebildetem Widerstandsstück mittels Reibschweißen verschweißt. Das so gebildete Widerstandselement wird in dem Bereich des Widerstandsstücks mit Hilfe einer Fräsvorrichtung an der Oberfläche gefräst, so dass das Widerstandsstück eine Vertiefung in der Oberfläche des Widerstandselements ausbildet. Auf den aus Kupfer gebildeten Anschlussstücken werden Anschlusskonsolen angeordnet. Mit den Anschlusskonsolen wird ein integrierter Schaltkreis verlötet, mit welchem zumindest die physikalischen Größen Strom, Spannung und/oder Temperatur des Widerstandsstücks auswertbar sind.

Das zuvor beschriebene Widerstandselement ist in seiner Herstellung aufwendig. Beim Verschweißen zwischen dem Widerstandsstück und den Anschlussstücken kann Schweißmaterial auf das Widerstandsstück spritzen und somit die Leitfähigkeit des Widerstandsstücks verändern, was zu Problemen in der Messgenauigkeit führt. Darüber hinaus wird beim Verschweißen des Widerstandsstücks mit den Anschlussstücken Temperatur in das Widerstandselement eingebracht, was zu thermischen Spannungen zwischen dem Widerstandsstück und den Anschlussstücken führen kann. Um diese thermischen Spannungen zu lösen, ist es notwendig, das Widerstandselement vor der Montage mit der integrierten Schaltung thermisch zu entspannen (tempern).

Ferner muss verhindert werden, dass der integrierte Schaltkreis außer an den dafür vorgesehenen elektrischen Kontakten in elektrischen Kontakt mit dem Widerstandselement tritt. Aus diesem Grunde wird, wie zuvor erwähnt, das Widerstandsstück überfräst, so dass eine Stufe im Widerstandselement gebildet wird. Im Bereich dieser Stufe wird der integrierte Schaltkreis angeordnet, so dass ein genügend großer Abstand zwischen Widerstandselement und den Kontakten des integrierten Schaltkreises gewährleistet ist.

Aus den zuvor gezeigten Nachteilen ergibt sich das Problem, ein Widerstandselement für einen Kraftfahrzeugbatteriesensor zur Verfügung zu stellen, welches einfach in der Herstellung als auch der Handhabung ist.

Das zuvor aus dem Stand der Technik hergeleitete und aufgezeigte Problem wird durch einen Kraftfahrzeugbatteriesensor nach Anspruch 1 sowie ein Verfahren nach Anspruch 13 gelöst.

Dadurch, dass das Widerstandselement als Flachteil gebildet ist, wird vermieden, dass eine Stufe gefräst werden muss. Durch das Aufbringen der Kontakte flächig auf der Oberfläche des Widerstandselementes dienen die Kontakte unmittelbar als Abstandhalter für einen integrierten Schaltkreis, so dass eine Kontaktierung zwischen integriertem Schaltkreis und Widerstandselement außerhalb der Kontakte vermieden werden kann. Dadurch, dass das Widerstandselement als Flachteil gebildet ist, können die Kontakte entlang der Oberfläche des Widerstandselements flächig angeordnet sein.

Die Kontakte sind aus flächig auf der Oberfläche des Widerstandselements angeordneten flachen oder runden elektrischen Leitern gebildet. Beispielsweise ist es möglich, einen Runddraht entlang der Oberfläche des Flachteils anzuordnen und elektrisch mit dem Widerstandselement zu verbinden. Liegen die Kontakte in einem definierten Abstand zueinander, so ist es möglich, über die zwischen den Kontakten gemessene Spannung den Stromfluß im Widerstandselement bestimmen zu können. Durch eine große Auflagefläche zwischen den Kontakten und dem Widerstandselement wird ermöglicht, dass eine Temperatursensierung in einem mit den Kontakten verbundenen integrierten Schaltkreis genau ist. Es ist auch möglich, dass Flachprofile als Leiter mit dem Widerstandselement kontaktiert werden, um die Kontakte zu bilden.

Auch wird vorgeschlagen, dass die Kontakte im Wesentlichen orthogonal zur Stromausbreitungsrichtung im Widerstandselement auf der Oberfläche des Widerstandselements angeordnet sind. Die flächige Anordnung der Kontakte auf dem Widerstandselement kann im Wesentlichen entlang einer Linie erfolgen. Eine flächige Anordnung der Kontakte auf dem Widerstandselement bietet im Gegensatz zu einer punktuellen Anordnung neben einem geringen Übergangswiderstand und guter thermische Zeitfähigkeit eine Stützfunktion für einen auf den Kontakten aufgebrachten integrierten Schaltkreis.

Um einen guten elektrischen Kontakt zwischen Widerstandselement und Kontakt herzustellen, wird vorgeschlagen, dass die Kontakte stoffschlüssig mit dem Widerstandselement verbunden sind.

Eine derartige stoffschlüssige Verbindung kann beispielsweise mittels Ultraschallschweißen hergestellt werden. Beim Ultraschallschweißen wird vermieden, dass Materialspritzer auf das Widerstandselement spritzen und somit die Messergebnisse eventuell verfälschen. Eine gute elektrische Kontaktierung und eine hohe mechanische Tragfähigkeit der Kontakte für einen integrierten Schaltkreis wird dadurch erreicht, dass die Kontakte im Wesentlichen flächig entlang ihrer Ausbreitungsrichtung mit dem Widerstandselement verbunden sind.

Es ist nicht notwendig, dass die flächig auf dem Flachteil aufliegenden Kontakte entlang der gesamten Auflagefläche elektrisch mit dem Widerstandselement kontaktiert werden. Es ist auch möglich, dass die Kontakte lediglich punktuell stoffschlüssig mit dem Widerstandselement verbunden werden.

Eine möglichst große Auflagefläche zwischen Kontakten und Widerstandselementen wird dadurch gewährleistet, dass die Kontakte auf der breiten Oberfläche des als Flachteil gebildeten Widerstandselements angeordnet sind.

Eine besonders einfache Kontaktierung eines integrierten Schaltkreises mit den Kontakten wird dadurch gewährleistet, dass die Kontakte an ihren beiden Enden derart gebogen sind, dass Kontaktstifte im Wesentlichen orthogonal aus der Oberflächenebene des Widerstandselements ragen. Beispielsweise ist es möglich, beim Herstellen die Kontakte über die Kanten des Widerstandselementes herausragen zu lassen. So ist es beispielsweise möglich, die Kontakte, die beispielsweise als Drähte gebildet sind, derart abzulängen, dass deren Länge geringfügig größer ist, als die Breite des Widerstandselements. Die Enden der Drähte stehen nach dem stoffschlüssigen Verbinden mit dem Widerstandselement über die Kanten des Widerstandselements ab. In einem weiteren Fertigungsschritt kann das mit den Kontakten verbundene Widerstandselement beispielsweise in eine Formgebungsmatrix gedrückt werden, welche die über die Kanten hinausstehenden Teile der Kontakte aus der Ebene der Oberfläche des Widerstandselements herausdrückt. Die so gebildeten Kontaktstifte ragen aus der Ebene des Widerstandselements heraus und eignen sich in besonderer Weise für eine elektrische Kontaktierung mit einem integrierten Schaltkreis.

Die Kontakte dienen zur Kontaktierung mit einem integrierten Schaltkreis, so dass mit Hilfe des integrierten Schaltkreises zumindest die elektrische Spannung zwischen den Kontakten ausgewertet werden kann.

Durch das flächige Aufbringen der Kontakte auf dem Widerstandselement bilden die Kontakte einen natürlichen Abstandhalter. Ein auf den Kontaktstiften aufgebrachter integrierter Schaltkreis wird durch die Kontakte vor einer mechanischen Kontaktierung mit dem Widerstandselement geschützt. Im Bereich der Kontakte kann die integrierte Schaltung so gebildet sein, dass die den Kontakten zugewandte Seite frei von Lötpunkten ist, so dass lediglich die Platine der integrierten Schaltung auf den Kontakten aufliegt und somit eine elektrische Kontaktierung mit Elementen der integrierten Schaltung vermieden wird.

Zwischen dem Widerstandselement und dem integrierten Schaltkreis kann es zu mechanischen Spannungen kommen. Beispielsweise ist es möglich, dass auf dem integrierten Schaltkreis Kräfte einwirken, die zu einer Scherbewegung oder einer Drehbewegung des integrierten Schaltkreises im Verhältnis zum Widerstandselement führen. Diese Kräfte können mit Hilfe der Kontakte aufgenommen werden. Die Kontakte dienen somit als natürliches Federelement zwischen dem integrierten Schaltkreis und dem Widerstandselement.

Neben einer Kontaktierung der Kontakte mit dem integrierten Schaltkreis mittels Löten ist es auch möglich, dass der integrierte Schaltkreis mit Hilfe eines mechanischen Kontaktelementes mit den Kontakten verbunden ist. Solche mechanische Kontaktelemente können beispielsweise Clipse sein, welche auf die Kontakte aufgeclipst werden.

Bei herkömmlichen Kraftfahrzeugbatteriesensorelementen, bei denen im Bereich des Widerstandsstücks eine Stufe in der Oberfläche des Widerstandselementes gebildet ist, kann der integrierte Schaltkreis nur im Bereich der Stufe und in daran angrenzenden Bereichen angeordnet sein. Dies begrenzt die Größe des integrierten Schaltkreises. Gemäß einer Lösung eines Ausführungsbeispiels wird vorgeschlagen, dass das Flächenverhältnis zwischen integrierter Schaltung und Widerstandselement größer als 1 bevorzugt größer als 1,4 ist. Dadurch, dass der Kontakt zwischen integrierter Schaltung und Widerstandselement durch die flächig auf dem Widerstandselement angeordneten Kontakte hergestellt ist und eine mechanische Kontaktierung zwischen Widerstandselement und integrierter Schaltung hierdurch vermieden wird, ist es möglich, die integrierte Schaltung auch größer als das Widerstandselement selbst zu gestalten.

Das Widerstandselement kann gemäß eines bevorzugten Ausführungsbeispiels einstückig gebildet sein. Bei einem einstückigen Widerstandselement entfällt ein Verschweißen mit Anschlussstücken und es werden keine thermischen Spannungen in das Widerstandselement eingetragen. Hierdurch kann ein Tempern des Widerstandselements entfallen, was die Herstellungskosten reduziert.

Es ist auch möglich, dass das Widerstandselement aus zumindest zwei elektrischen Anschlussstücken und einem Widerstandsstück gebildet ist. Die elektrischen Anschlussstücke können beispielsweise aus einem Nichteisenmetall, beispielsweise Kupfer oder Aluminium oder Legierung hieraus gebildet sein. Durch das Anordnen von Anschlussstücken ist es eventuell leichter, einen elektrischen Übergang mit dem Energieleiter des Bordnetzes zur Verfügung zu stellen, da mit Hilfe der Anschlussstücke ein Kabelschuh oder eine andere Aufnahme für den Energieleiter geschaffen werden kann.

Die Kontakte können gemäß eines vorteilhaften Ausführungsbeispiels entweder im Bereich des Widerstandsstücks selbst, auf den Übergängen zwischen dem Widerstandsstück und den Anschlussstücken oder auf den Anschlussstücken angeordnet sein.

Eine günstige Herstellung des Widerstandselements ist dadurch gewährleistet, dass das Widerstandselement aus von Stangen gestanzten oder geschnittenen Flachteilen gebildet ist. Werden die Widerstandselemente aus Stangenware hergestellt, so entfällt ein Tempern, da anderenfalls, wenn das Material der Widerstandselemente von einem Coil abgewickelt worden wäre, Spannungen im Widerstandselement entstünden.

Für den Fall, dass das Material der Widerstandselemente von einem Coil verarbeitet wird, wird gemäß eines vorteilhaften Ausführungsbeispiel vorgeschlagen, dass das Widerstandselement aus einem zunächst von einem Coil abgewickelten, dann gestanzten oder geschnittenen und abschließend getemperten Flachteil gebildet ist.

Bevorzugt wird die Verwendung der Materialien NiCu30Fe, CuMn12Ni, CuNi30Mn, NiFe30, CuNi23Mn, CuMn7Sn, CuNi15, CuNi10, CuMn3, CuNi6, Ni99,6, Ni99,4Fe, Ni99,98, CuNi2, CuNi1, E-Cu57 oder W. Diese Legierungen oder Materialien eignen sich in besonderem Maße als Widerstandselement, da sie eine genaue Bestimmung der Spannung und der Stroms erlauben.

Nachfolgend wird der Gegenstand anhand einer Ausführungsbeispiele zeigenden Zeichnung näher erläutert. In der Zeichnung zeigen:
- Fig. 1a: eine Ansicht eines herkömmlichen Widerstandselements;
- Fig. 1b: eine Schnittansicht eines herkömmlichen Widerstandelements;
- Fig. 1c: eine Draufsicht auf ein herkömmliches Widerstandselement;
- Fig. 2: eine Ansicht eines ersten Widerstandselements gemäß eines Ausführungsbeispiels;
- Fig. 3: eine Ansicht eines zweiten Widerstandselements gemäß eines Ausführungsbeispiels;
- Fig. 4a: eine Schnittansicht eines Widerstandselements gemäß eines Ausführungsbeispiels;
- Fig. 4b: eine weitere Schnittansicht eines Widerstandselements gemäß eines Ausführungsbeispiels;
- Fig. 4c: eine weitere Schnittansicht eines Widerstandselements gemäß eines Ausführungsbeispiels;
- Fig. 5: eine Schnittansicht eines Widerstandselements mit einer integrierten Schaltung;
- Fig. 6: eine weitere Schnittansicht eines Widerstandselements mit einer integrierten Schaltung, welche nicht von den Ansprüchen umfasst ist;
- Fig. 7: eine Draufsicht auf ein Widerstandselement;
- Fig. 8: ein Ablauf eines Verfahrens gemäß eines Ausführungsbeispiels.

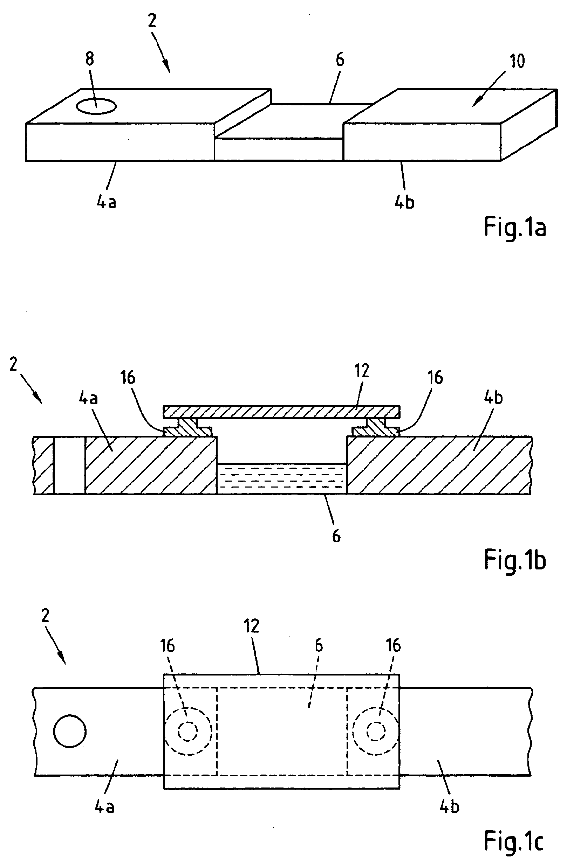

Fig. 1 zeigt ein Widerstandselement 2 mit zwei Anschlussstücken 4a, 4b und einem Widerstandsstück 6. Die Anschlussstücke 4a, 4b können beispielsweise aus Kupfer oder Legierungen davon gebildet sein. Das Widerstandsstück 6 kann aus einem Widerstandsmaterial, beispielsweise Manganin, Wolfram, Zeranin oder dergleichen gebildet sein. Zwischen den Anschlusstücken 4a, 4b und dem Widerstandsstück 6 besteht eine stoffschlüssige Verbindung. Das Widerstandsstück 6 ist derart gebildet, dass es mit der Oberfläche der Anschlussstücke 4a, 4b eine Stufe bildet. Dies kann beispielsweise dadurch geschehen, dass ein Widerstandsstück 6 im Bereich der Stufe gefräst wird. Auch ist es möglich, dass ein Widerstandsstück 6 mit geringerer Stärke als die Anschlussstücke 4a, 4b mit den Anschlussstücken 4a, 4b stoffschlüssig verbunden wird. Die Anschlussstücke 4a, 4b können Aufnahmen 8 für Energieleiter aufweisen. Die Anschlussstücke 4a, 4b können derart geformt sein, dass sie eine Batterieklemme bilden und einen Anschluss an einen Energieleiter in einem Kraftfahrzeug ermöglichen.

Die durch das Widerstandsstück 6 gebildete Stufe in der Oberfläche 10 des Widerstandselements 2 wird verwendet, um, wie in Figur 1b gezeigt, einen ausreichenden Abstand zwischen einer integrierten Schaltung 12 und dem Widerstandsstück 6 zu gewährleisten. Die integrierte Schaltung 12 ist mittels Kontakte elektrisch mit den Anschlussstücken 4a, 4b kontaktiert. Die Kontakte 16 sind punktuell auf der Oberfläche 10 des Widerstandselements 2 angeordnet. Über die Kontakte 16 lässt sich die über das Widerstandsstück 6 abfallende Spannung messen. Auch erlauben die Kontakte 16 ein Abgreifen der Temperatur der Anschlussstücke 4a, 4b, welche neben anderen physikalischen Größen in der integrierten Schaltung 12 ausgewertet wird.

Figur 1c zeigt eine Draufsicht auf ein Widerstandselement 2. Zu erkennen ist, dass die Kontakte 16 punktförmig auf den Anschlussstücken 4a, 4b angeordnet sind. Der integrierte Schaltkreis 12 ist im Bereich des Widerstandsstücks 6 angeordnet und über die Kontakte 16 mit den Anschlussstücken 4a, 4b in elektrischem Kontakt.

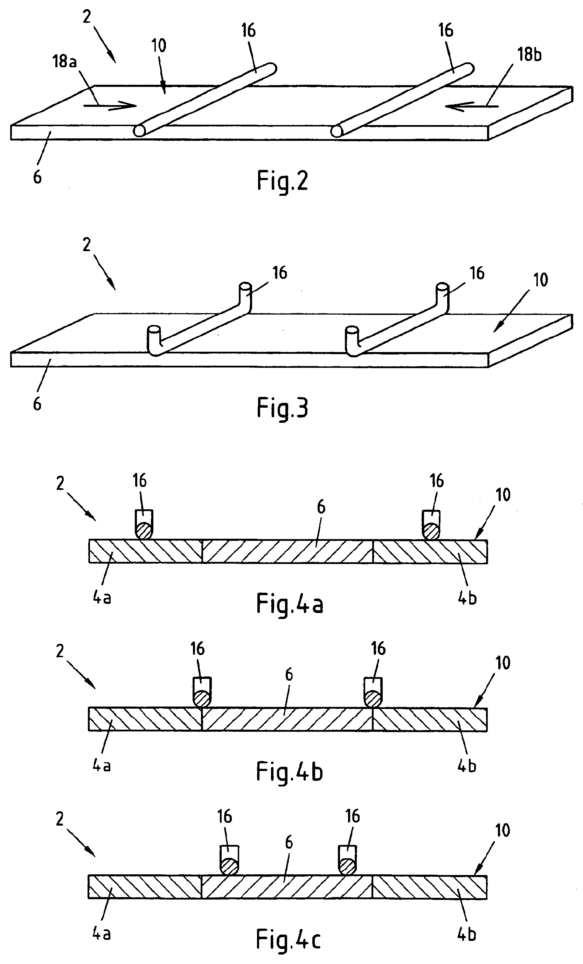

Figur 2 zeigt ein Widerstandselement 2 gemäß eines Ausführungsbeispiels. Zu erkennen ist, dass die Kontakte 16 auf der Oberfläche 10 des Widerstandselements 2, welches gemäß des gezeigten Ausführungsbeispiels als einziges Widerstandsstück 6 gebildet ist, angeordnet sind. Durch Pfeile 18 sind die beiden möglichen Stromflussrichtungen im Widerstandselement 2 angedeutet. Der Strom fließt durch das Widerstandselement 2 in Richtung des Pfeils 18a oder in Richtung des Pfeils 18b. Zu erkennen ist, dass die flächig auf dem Widerstandselement 2 angeordneten Kontakte 16 orthogonal zu der Stromflussrichtung auf der Oberfläche 10 des Widerstandselements 2 angeordnet sind. Die Kontakte 16 sind bevorzugt mittels Ultraschalschweißen auf der Oberfläche 10 des Widerstandselements 2 aufgebracht. Die Kontakte 16 sind bevorzugt als Drähte gebildet, können jedoch auch als Profilleiter mit einem rechteckigen oder quadratischen Querschnitt gebildet sein. Wie zu erkennen ist, ragen die Kontakte 16 über die Kanten des Widerstandselements hinaus. Die Kontakte 16 sind auf der Oberfläche 10, welches die breite Oberfläche des Widerstandselements 2 ist, angeordnet. Entlang ihrer Ausbreitungsrichtung sind die Kontakte 16 mit der Oberfläche 10 des Widerstandselements 2 verbunden. Über die Kontakte 16 kann eine integrierte Schaltung 12 mit dem Widerstandselement 2 verbunden werden.

Eine besonders gute Kontaktierung einer integrierten Schaltung 12 mit dem Widerstandselement 2 ist beispielsweise dann möglich, wenn die Kontakte 16, wie in Figur 3 gezeigt, an den Kanten des Widerstandselements 2 gebogen sind, derart, dass die Enden der Kontakte 16 aus der Ebene der Oberfläche 10 des Widerstandselements 2 herausragen.

Figur 4a zeigt eine Schnittansicht eines Widerstandelements 2 mit einer möglichen Anordnung der Kontakte 16. Das Widerstandselement 2 ist aus Anschlussstücken 4a, 4b und einem Widerstandsstück 6 gebildet. Wie zu erkennen ist, sind die Kontakte 16 im Bereich der Anschlussstücke 4 angeordnet. Ferner ist zu erkennen, dass die Enden der Kontakte 16 als Kontaktstifte gebildet sind und aus der Ebene 10 des Widerstandselements 2 herausragen. Über diese Kontaktstifte kann eine integrierte Schaltung 12 mit dem Widerstandselement 2 kontaktiert werden.

Figur 4b zeigt eine weitere Möglichkeit der Anordnung der Kontakte 16 auf dem Widerstandselement 2. In dem in Figur 4b gezeigten Beispiel sind die Kontakte 16 im Bereich der Kontaktstelle zwischen Anschlussstücken 4a, 4b und Widerstandsstück 6 angeordnet. Beispielsweise können die Kontakte 16 im Bereich der Schweißnaht zwischen den Anschlussstücken 4 und dem Widerstandsstück 6 angeordnet sein.

Eine weitere Möglichkeit der Anordnung der Kontakte 16 auf dem Widerstandselement 2 ist in Figur 4c gezeigt. In dem gezeigten Beispiel sind die Kontakte 16 im Bereich des Widerstandsstücks 6 angeordnet.

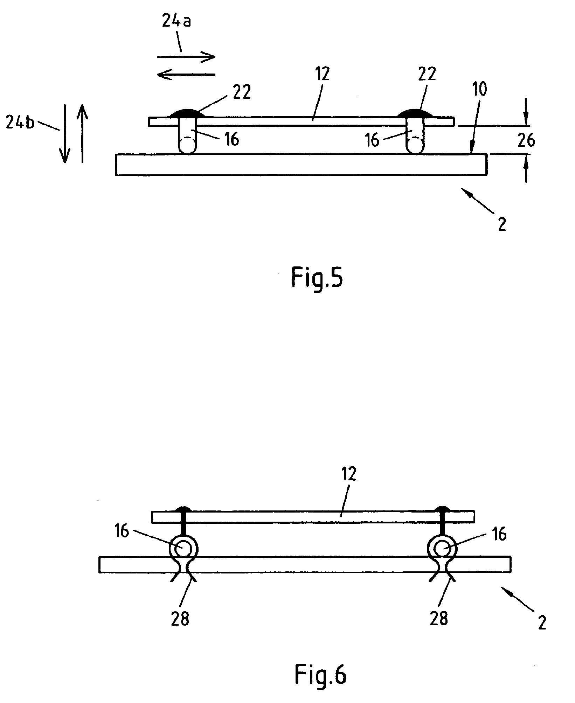

Figur 5 zeigt eine Seitenansicht eines Widerstandselements 2 mit einer integrierten Schaltung 12. Das Widerstandselement 2 ist über die Kontakte 16 mit der integrierten Schaltung 12 kontaktiert. Die Kontakte 16 sind mit dem integrierten Schaltkreis 12 über Lötpunkte 22 verbunden. Die Kontakte 16 sind an ihren Enden gebogen, so dass Kontaktstifte entstehen, über welche der integrierte Schaltkreis 12 mit dem Widerstandselement 2 elektrisch verbunden ist. Dadurch, dass die Kontaktstifte der Kontakte 16 aus der Ebene 10 des Widerstandselements 2 herausragen, können Kräfte 24, welche auf die integrierte Schaltung 12 oder das Widerstandselement 2 wirken, zwischen Widerstandselement 2 und integrierter Schaltung 12 ausgeglichen werden. Die Kontaktstifte dienen somit als Federelemente, welche Kräfte aufnehmen können. Wie zu erkennen ist, ist der Abstand 26 zwischen der integrierten Schaltung 12 und dem Widerstandselement 2 durch den Durchmesser der Drähte der Kontakte 16 bestimmt. Die Drähte der Kontakte 16 dienen somit als Abstandhalter zwischen Widerstandselement 2 und integrierter Schaltung 12.

Eine Kontaktierung zwischen Widerstandselement 2 und integrierter Schaltung 12 ist beispielsweise auch möglich durch ein mechanisches Halteelement 28. Die Kontakte 16 können dabei so geformt sein, dass sie über die Kanten des Widerstandselements 2 herausragen. An den herausragenden Enden können die mechanischen Halteelemente 28 befestigt werden. In der Zeichnung 6 sind die mechanischen Befestigungselemente 28 nicht in unmittelbarem Kontakt mit den Kontakten 16, welches lediglich zur Verdeutlichung der Zeichnung dient. In einer Anwendung wären die mechanischen Halteelemente 28 in unmittelbarem mechanischen und elektrischen Kontakt mit den Kontakten 16. Über die mechanischen Halteelemente 28 werden die Kontakte 16 mit der integrierten Schaltung 12 elektrisch verbunden.

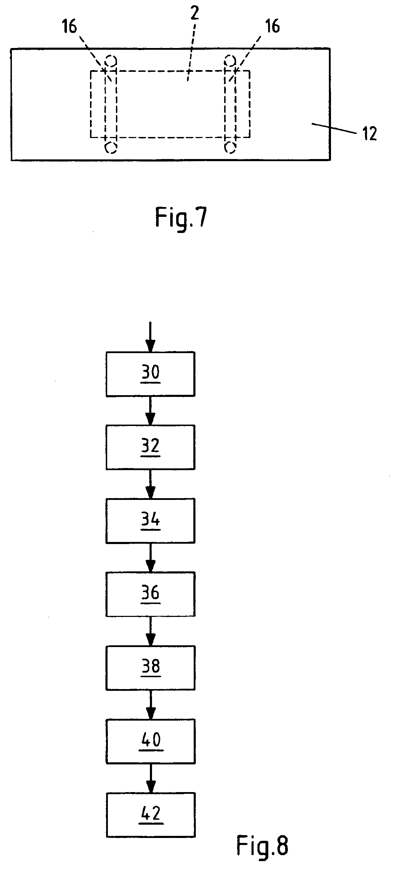

Figur 7 zeigt eine Draufsicht auf ein Widerstandselement 2. Das Widerstandselement 2 mit den Kontakten 16 ist unterhalb des integrierten Schaltkreises 12 angeordnet. Wie zu erkennen ist, ist die Fläche des integrierten Schaltkreises 12 erheblich größer als die durch das Widerstandselement 2 eingenommene Fläche. Dadurch, dass die Kontakte 16, welche flächig auf der Oberfläche des Widerstandselements 2 angeordnet sind, einen natürlichen Abstandhalter zwischen integrierter Schaltung 12 und Widerstandselement 2 bilden, kann die integrierte Schaltung 12 eine erheblich größere Fläche einnehmen, als das Widerstandselement 2, ohne dass Kontaktierungen zwischen Widerstandselement 2 und integrierter Schaltung 12 zu befürchten sind.

Figur 8 zeigt ein Ablaufdiagramm eines Herstellungsverfahrens. In einem ersten Schritt 30 wird ein Widerstandsmaterial, beispielsweise Manganin, von einem Coil abgewickelt. Das abgewickelte Material wird in einem weiteren Schritt 32 abgelängt bzw. gestanzt oder geschnitten, so dass es die Form des späteren Widerstandselements 2 bzw. des Widerstandsstücks 6 hat. Das abgelängte bzw. geschnittene und vom Coil abgewickelte Widerstandselement wird getempert 34, um die beim Abwickeln 30 entstandenen mechanischen Spannungen zu lösen.

Für den Fall, dass das Widerstandsmaterial nicht von einem Coil abgewickelt wird, können die Schritte 30, 34 entfallen.

Nachdem das Widerstandsmaterial abgewickelt 30, geschnitten oder gestanzt 32 und getempert 34 ist, wird ein Draht derart auf die Oberfläche des als Flachteil gebildeten Widerstandselements gelegt 36, dass der Draht entlang seiner Ausbreitungsrichtung mit der Oberfläche des Widerstandselements verbunden ist.

Der auf diese Weise flächig auf der Oberfläche des Widerstandselements angeordnete Draht wird mittels Ultraschalschweißen 38 mit dem Widerstandselement verbunden. Der Draht wurde vor dem Verschweißen 38 derart abgelängt, dass seine Länge größer ist, als die Breite der breiten Oberfläche des Widerstandselements. Beim Verschweißen 38 ist der Draht derart auf dem Widerstandselement angeordnet 36 worden, dass auf beiden Seiten der Kanten des Widerstandselements ein Ende des Drahtes absteht. Diese Enden werden mit einem geeigneten Werkzeug, beispielsweise einem Formgebungswerkzeug nach oben gebogen 40, so dass die Enden als Kontaktstifte aus der Ebene des Widerstandselements herausragen. Die Kontaktstifte werden verwendet, um das Widerstandselement mit einem integrierten Schaltkreis zu verbinden 42.

Durch das gezeigte Widerstandselement ist es möglich, ein Kraftfahrzeugbatteriesensorelement kostengünstig herzustellen. Das Kraftfahrzeugbatteriesensorelement ermöglicht eine genaue Messung von Strom, Spannung und Temperatur des Widerstandselements und die mechanischen Eigenschaften des anmeldungsgemäßen Kraftfahrzeugbatteriesensorelements eignen sich besonders gut, um das Kraftfahrzeugbatteriesensorelement mit einer integrierten Schaltung zu verbinden.

## Patentansprüche

1. Kraftfahrzeugbatteriesensorelement mit
- einem Widerstandselement (2), und
- zumindest zwei auf dem Widerstandselement (2) angeordneten, räumlich voneinander getrennten elektrischen Kontakten (16),
- wobei das Widerstandselement (2) als ein eine ebene Oberfläche (10) aufweisendes Flachteil gebildet ist, und
- wobei die Kontakte (16) flächig auf der Oberfläche (10) des Widerstandselements (2) angeordnet sind, - wobei die Kontakte (16) aus flächig auf der Oberfläche (10) des Widerstandselements (2) angeordneten flachen oder runden elektrischen Leitern gebildet sind und
- wobei die zumindest zwei Kontakte (16) jeweils an ihren beiden Enden derart gebogen sind, dass so gebildete Kontaktstifte im Wesentlichen orthogonal aus der Oberflächenebene des Widerstandselements (2) ragen.

2. Kraftfahrzeugbatteriesensorelement nach einem der vorangehenden Ansprüche, **dadurch gekennzeichnet, dass** die Kontakte im Wesentlichen orthogonal zur Stromausbreitungsrichtung im Widerstandselement auf der Oberfläche des Widerstandselements angeordnet sind.

3. Kraftfahrzeugbatteriesensorelement nach einem der vorangehenden Ansprüche, **dadurch gekennzeichnet, dass** die Kontakte (16) stoffschlüssig mit dem Widerstandselement (2) verbunden sind.

4. Kraftfahrzeugbatteriesensorelement nach einem der vorangehenden Ansprüche, **dadurch gekennzeichnet, dass** eine Ultraschweißnaht die Kontakte (16) stoffschlüssig mit dem Widerstandselement (2) verbindet.

5. Kraftfahrzeugbatteriesensorelement nach einem der vorangehenden Ansprüche, **dadurch gekennzeichnet, dass** die Kontakte im Wesentlichen flächig entlang ihrer Ausbreitungsrichtung mit dem Widerstandselement (2) verbunden sind, und/oder dass die Kontakte (16) im Wesentlichen punktförmig mit dem Widerstandselement (2) stoffschlüssig verbunden sind, und/oder dass die Kontakte (16) auf der breiten Oberfläche (10) des Widerstandselements (2) angeordnet sind.

6. Kraftfahrzeugbatteriesensorelement nach einem der vorangehenden Ansprüche, **dadurch gekennzeichnet, dass** die Enden der Kontakte an den Kanten des Widerstandselements (2) gebogen sind, und/oder dass die Enden der Kontakte zur Aufnahme einer zumindest die elektrische Spannung (12) zwischen den Kontakten auswertende integrierten Schaltung gebildet sind.

7. Kraftfahrzeugbatteriesensorelement nach einem der vorangehenden Ansprüche, **dadurch gekennzeichnet, dass** die Kontakte (16) die integrierte Schaltung (12) von dem Widerstandselement (2) beabstanden, und/oder dass die Kontakte (16) zur Aufnahme von Torsionskräften und/oder Scherkräften zwischen dem Widerstandselement (2) und der integrierten Schaltung (12) gebildet sind, und/oder dass Anschlüsse der integrierten Schaltung mit den Kontakten mit Hilfe eines mechanischen Kontaktelements (28) verbunden sind.

8. Kraftfahrzeugbatteriesensorelement nach einem der vorangehenden Ansprüche, **dadurch gekennzeichnet, dass** das Flächenverhältnis zwischen integrierter Schaltung (12) und Widerstandselement (2) größer 1, bevorzugt größer 1,4 ist.

9. Kraftfahrzeugbatteriesensorelement nach einem der vorangehenden Ansprüche, **dadurch gekennzeichnet, dass** das Widerstandselement (2) einstückig gebildet ist.

10. Kraftfahrzeugbatteriesensorelement nach einem der vorangehenden Ansprüche, **dadurch gekennzeichnet, dass** das Widerstandselement (2) aus zumindest zwei elektrischen Anschlussstücken (4a, 4b) und einem Widerstandsstück (6) gebildet ist.

11. Kraftfahrzeugbatteriesensorelement nach einem der vorangehenden Ansprüche, **dadurch gekennzeichnet, dass** die Kontakte
A) im Bereich des Widerstandsstücks (6),
B) auf Übergängen zwischen dem Widerstandsstück (6) und den Anschlusstücken (4a, 4b), oder
C) auf den Anschlusstücken (2a, 4b)
angeordnet sind.

12. Kraftfahrzeugbatteriesensorelement nach einem der vorangehenden Ansprüche, **dadurch gekennzeichnet, dass** das Widerstandselement (2) zumindest teilweise aus NiCu30Fe, CuMn12Ni, CuNi30Mn, NiFe30, CuNi23Mn, CuMn7Sn, CuNi15, CuNi10, CuMn3, CuNi6, Ni99,6, Ni99,4Fe, Ni99,98, CuNi2, CuNi1, E-Cu57 oder W gebildet ist.

13. Verfahren zur Herstellung eines
Kraftfahrzeugbatteriesensorelements mit:
- flächigem Anordnen zweier räumlich voneinander getrennter elektrischer Kontakte (16) auf einem aus einem eine ebene Oberfläche (10) aufweisenden Flachteil gebildeten Widerstandselement (2),
- elektrischem Verbinden des Kontaktes (16) mit dem Widerstandselement (2),
- wobei die Kontakte (16) aus flächig auf der Oberfläche (10) des Widerstandselements (2) angeordneten flachen oder runden elektrischen Leitern gebildet sind und
- die zwei Kontakte (16) jeweils an ihren beiden Enden derart gebogen werden, dass so gebildete Kontaktstifte im Wesentlichen orthogonal aus der Oberflächenebene des Widerstandselements (2) ragen.

14. Verfahren nach Anspruch 13, wobei das Widerstandselement (2) aus von Stangen gestanzten oder geschnittenen Flachteilen gebildet wird, und/oder wobei das Widerstandselement (2) aus zunächst von einem Coil abgewickelten, dann gestanzten oder geschnittenen und abschließend getemperten Flachteil gebildet wird.

## Claims

1. Motor vehicle battery sensor element with
- a resistor element (2), and
- at least two spatially separated electrical contacts (16) positioned on the resistor element (2), wherein
- the resistor element (2) is in the form of a flat part having an even surface (10),
and wherein
- the contacts (16) are positioned areally on the surface (10) of the resistor element (2), wherein
the contacts (16) are in the form of flat or round electrical conductors positioned areally flat on the surface (10) of the resistor element (2), and wherein
- the at least two contacts (16) respectively are bent at both ends so that contact pins protrude substantially orthogonally from the surface plane (10) of the resistor element (2).

2. Motor vehicle battery sensor element according to one of the preceding claims, **characterised in that** the contacts are positioned substantially orthogonally to the direction of flow of the current in the resistor element on the surface of the resistor element.

3. Motor vehicle battery sensor element according to one of the preceding claims, **characterised in that** the contacts (16) are materially connected (material closure) with the resistor element (2).

4. Motor vehicle battery sensor element according to one of the preceding claims, **characterised in that** the contacts (16) are materially connected with the resistor element (2) by means of ultrasonic welding.

5. Motor vehicle battery sensor element according to one of the preceding claims, **characterised in that** the contacts substantially have an areal connection along their direction of propagation with the resistor element (2), and/or that the contacts (16) substantially have a punctual material closure with the resistor element (2),and/or that the contacts (16) are positioned on the broad surface (10) of the resistor element (2).

6. Motor vehicle battery sensor element according to one of the preceding claims, **characterised in that** the ends of the contacts are bent at the edges of the resistor element (2), and/or that the ends of the contacts (16) are formed to accommodate an integrated circuit (12) to assess at least the electrical voltage between the contacts.

7. Motor vehicle battery sensor element according to one of the preceding claims, **characterised in that** the contacts (16) space the integrated circuit (2) from the resistor element (2), and/or that the contacts (16) are designed to absorb torsional forces and/or shearing forces between the resistor element (2) and the integrated circuit (12), and/or that connections of the integrated circuit are connected with the contacts with the help of a mechanical contact element (28).

8. Motor vehicle battery sensor element according to one of the preceding claims, **characterised in that** the ratio of the areas of integrated circuit (12) and resistor element (2) is greater than 1, preferably greater than 1.4.

9. Motor vehicle battery sensor element according to one of the preceding claims, **characterised in that** the resistor element (2) is made from one piece.

10. Motor vehicle battery sensor element according to one of the preceding claims, **characterised in that** the resistor element (2) is made from at least two electrical connection pieces (4a, 4b) and one resistance piece (6).

11. Motor vehicle battery sensor element according to one of the preceding claims, **characterised in that** the contacts are positioned
A) in the area of the resistance piece (6),
B) on transitions between the resistance piece (6) and the connection pieces (4a, 4b), or
C) on the connection pieces (2a, 4b).

12. Motor vehicle battery element according to one of the preceding claims, **characterised in that** the resistor element (2) is at least in part made from NiCu30Fe, CuMn12Ni, CuNi30Mn, NiFe30, CuNi23Mn, CuMn7Sn, CuNi15, CuNi10, CuMn3, CuNi6, Ni99.6, Ni99.4Fe, Ni99.98, CuNi2 , CuNi1, E-Cu57 or W.

13. Method for producing a motor vehicle battery sensor element with:
- areal arrangement of two spatially separated electrical contacts (6) on a resistor element (2) made from a flat part having an even surface (10);
- electrical connection of the contact (16) to the resistor element (2), wherein
- the contacts (16) are in the form of flat or round electrical conductors positioned a really on the surface (10) of the resistor element (22), and
- the two contacts respectively are bent at both ends, so that contact pins protrude substantially orthogonally from the surface plane of the resistor element.

14. Method according to claim 13, wherein the resistor element is formed from flat pieces punched or cut from bars, and/or wherein the resistor element is formed from a flat piece, which first is unwound from a coil, the punched or cut and finally tempered.

## Revendications

1. Elément détecteur de batterie d'un véhicule automobile comprenant
- un élément de résistance (2), et
- au moins deux contacts électriques (16) séparés physiquement l'un de l'autre et disposés sur l'élément de résistance (2),
- où l'élément de résistance (2) est formé comme une partie plate présentant une surface plane (10), et
- où les contacts (16) sont disposés à plat sur la surface (10) de l'élément de résistance (2),
- où les contacts (16) sont formés à partir de conducteurs électriques plats ou ronds disposés à plat sur la surface (10) de l'élément de résistance (2), et
- où les contacts (16) au moins au nombre de deux sont recourbés à chaque fois au niveau de leurs deux extrémités, de manière telle que des fiches de contact ainsi formées dépassent, pratiquement de façon orthogonale, du plan de surface de l'élément de résistance (2).

2. Elément détecteur de batterie d'un véhicule automobile selon la revendication 1, **caractérisé en ce que** les contacts sont disposés sur la surface de l'élément de résistance, pratiquement de façon orthogonale par rapport à la direction de propagation du courant dans l'élément de résistance.

3. Elément détecteur de batterie d'un véhicule automobile selon l'une ou l'autre des revendications précédentes, **caractérisé en ce que** les contacts (16) sont reliés à l'élément de résistance (2), par continuité de matière.

4. Elément détecteur de batterie d'un véhicule automobile selon l'une quelconque des revendications précédentes, **caractérisé en ce qu'**un cordon de soudure par ultrasons relie les contacts (16) à l'élément de résistance (2), par continuité de matière.

5. Elément détecteur de batterie d'un véhicule automobile selon l'une quelconque des revendications précédentes, **caractérisé en ce que** les contacts sont reliés à l'élément de résistance (2), pratiquement à plat le long de la direction de leur étendue, et/ou en ce que les contacts (16) sont reliés à l'élément de résistance (2), par continuité de matière, pratiquement de façon ponctuelle, et/ou **en ce que** les contacts (16) sont disposés sur la surface large (10) de l'élément de résistance (2).

6. Elément détecteur de batterie d'un véhicule automobile selon l'une quelconque des revendications précédentes, **caractérisé en ce que** les extrémités des contacts sont recourbées au niveau des arêtes de l'élément de résistance (2), et/ou **en ce que** les extrémités des contacts sont formées pour la réception d'un circuit intégré exploitant au moins la tension électrique (12) existant entre les contacts.

7. Elément détecteur de batterie d'un véhicule automobile selon l'une quelconque des revendications précédentes, **caractérisé en ce que** les contacts (16) placent le circuit intégré (12) à distance de l'élément de résistance (2), et/ou **en ce que** les contacts (16) sont formés pour absorber des forces de torsion et/ou des forces de cisaillement s'exerçant entre l'élément de résistance (2) et le circuit intégré (12), et/ou **en ce que** des connexions du circuit intégré sont reliées aux contacts à l'aide d'un élément de contact mécanique (28).

8. Elément détecteur de batterie d'un véhicule automobile selon l'une quelconque des revendications précédentes, **caractérisé en ce que** le rapport de surface existant entre le circuit intégré (12) et l'élément de résistance (2) est supérieur à 1, de préférence supérieur à 1,4.

9. Elément détecteur de batterie d'un véhicule automobile selon l'une quelconque des revendications précédentes, **caractérisé en ce que** l'élément de résistance (2) est formé d'une seule et même pièce.

10. Elément détecteur de batterie d'un véhicule automobile selon l'une quelconque des revendications précédentes, **caractérisé en ce que** l'élément de résistance (2) est formé à partir au moins de deux pièces de connexion électriques (4a, 4b) et d'une pièce de résistance (6).

11. Elément détecteur de batterie d'un véhicule automobile selon l'une quelconque des revendications précédentes, **caractérisé en ce que** les contacts sont disposés
A) dans la zone de la pièce de résistance (6),
B) sur des passages formés entre la pièce de résistance (6) et les pièces de connexion (4a, 4b), ou
C) sur les pièces de connexion (4a, 4b).

12. Elément détecteur de batterie d'un véhicule automobile selon l'une quelconque des revendications précédentes, **caractérisé en ce que** l'élément de résistance (2) est formé en étant composé au moins partiellement de NiCu30Fe, de CuMn12Ni, de CuNi30Mn, de NiFe30, de CuNi23Mn, de CuMn7Sn, de CuNi15, de CuNi10, de CuMn3, de CuNi6, de Ni99,6, de Ni99,4Fe, de Ni99,98, de CuNi2, de CuNi1, de E-Cu57 ou de W.

13. Procédé de fabrication d'un élément détecteur de batterie d'un véhicule automobile comprenant :
- la disposition à plat de deux contacts électriques (16) séparés physiquement l'un de l'autre, sur un élément de résistance (2) formé à partir d'une partie plate présentant une surface plane (10),
- la connexion électrique du contact (16) avec l'élément de résistance (2),
- où les contacts (16) sont formés à partir de conducteurs électriques plats ou ronds disposés à plat sur la surface (10) de l'élément de résistance (2), et
- les deux contacts (16) sont recourbés à chaque fois au niveau de leurs deux extrémités, de manière telle que des fiches de contact ainsi formées dépassent, pratiquement de façon orthogonale, du plan de surface de l'élément de résistance (2).

14. Procédé selon la revendication 13, dans lequel l'élément de résistance (2) est formé à partir de parties plates de barres, estampées et découpées, et/ou dans lequel l'élément de résistance (2) est formé à partir d'une partie plate qui est d'abord déroulée depuis une bobine de tôle, puis estampée ou découpée et enfin malléabilisée.
